# EUROPEAN PATENT APPLICATION

(11) **EP 3 772 417 A2**
(43) Date of publication of application: **10.02.2021**
(21) Application number: 20182118.8
(22) Date of filing: 24.06.2020
(51) Int. Cl.: B41N 10/02, B41N 10/04, B41M 1/06

(54) **IMAGING BLANKET AND METHOD OF MAKING THE IMAGING BLANKET**

(30) Priority: 18.07.2019 US 201916516120
(71) Applicant: Xerox Corporation, Webster, NY 14580 (US)
(72) Inventor: SAMBHY, Varun, Pittsford, NY 14534 (US); TALLMAN, Kyle B., Perry, NY 14530 (US); MA, Lin, Pittsford, NY 14534 (US); BADESHA, Santokh S., Pittsford, NY 14534 (US); ROETKER, Michael S., Webster, NY 14580 (US)
(74) Representative: Gill Jennings & Every LLP

(57) **Abstract**

An imaging blanket for variable data lithography. The imaging blanket comprises a substrate. A foam layer is disposed on the substrate. An elastomeric layer is disposed on the foam layer, the elastomeric layer comprising a silicone elastomer. The elastomeric layer has a Shore A hardness ranging from about 50 Shore A to about 100 Shore A.

## Description

### DETAILED DESCRIPTION

### Field of the Disclosure

This disclosure relates generally to marking and printing systems, and more specifically to an imaging blanket of such a system.

### Background

Typical lithographic and offset printing techniques use plates that are permanently patterned and are therefore useful only when printing a large number of copies of the same image (*i*.*e*., long print runs), such as magazines, newspapers, and the like. However, they do not permit creating and printing a new pattern from one page to the next without removing and replacing the print cylinder and/or the imaging plate (*i.e.*, the technique cannot accommodate true high speed variable data printing wherein the image changes from impression to impression, for example, as in the case of digital printing systems). Furthermore, the cost of the permanently patterned imaging plates or cylinders is amortized over the number of copies. The cost per printed copy is therefore higher for shorter print runs of the same image than for longer print runs of the same image, as opposed to prints from digital printing systems.

Accordingly, a lithographic technique, referred to as variable data lithography, has been developed which uses an imaging member comprising a non-patterned reimageable surface or imaging blanket that is initially uniformly coated with a dampening fluid layer. Regions of the dampening fluid are removed by exposure to a focused radiation source (e.g., a laser light source) to form pockets. A temporary pattern in the dampening fluid is thereby formed over the non-patterned imaging blanket. Ink applied thereover is retained in the pockets formed by the removal of the dampening fluid. The inked surface is then brought into contact with a print substrate, and the ink transfers from the pockets in the dampening fluid layer to the print substrate. The dampening fluid may then be removed, a new uniform layer of dampening fluid applied to the imaging blanket, and the process repeated.

Imaging blankets often employ a seamless engineered rubber substrate, such as, for example, a substrate known as a carcass. As an example, U.S. Patent Application Publication No. 2017/0341452 employs a sulfur free carcass for use in an imaging blanket. However, other types of carcass are available, including existing carcass used in the litho/flexo industry that are based on NBR (nitrile butadiene rubber). These NBR rubber carcass have sulfur which is used as a crosslinker.

The imaging blanket comprises a low surface energy coating, for example a dispersion comprising fluorosilicone and infrared-absorbing fillers such as carbon black. This dispersion is typically applied as a wet film onto the carcass and then cured at a high temperature, such as at about 160 °C for about 4 hours, to yield the final imaging blanket. Carcasses, such as those manufactured from Trelleborg AB (Trelleborg, Sweden) typically contain reinforcing fabric layers, a compressible foam layer, and a top rubber layer. Such engineered carcasses may have poor thermal conductivity. Accordingly, repeat multiple image printing, especially of high solids areas, can lead to the image blanket heating up in an image area. For example, multiple revolutions of the drum during repeat printing may cause the temperature of the area where laser imaged on an imaging blanket surface to rise much higher than the non-image area. The higher temperature of the blanket surface in the image area may lead to abnormally low vapor deposition of the dampening fluid in that hot area. A lower level of dampening fluid in a hot area may in turn lead to the appearance image quality defects in prints, such as latent images, ghosting, and/or thermal blooming.

There is a need in the art for imaging blankets having improved thermal conductivity, such that the temperature of the imaging blanket does not increase by a detrimental amount. There is also a need in the art for imaging blankets that do not include sulfur.

### SUMMARY

Rubber substrates used in carcasses of imaging blankets on which fluoropolymers, such as fluorosilicone, are coated and cured have often been based on nitrile butadiene rubber (NBR). A dispersion of fluorosilicone and carbon black have been applied as wet film on such carcasses and then cured at high temperature to yield a final imaging blanket. The inventors have recognized, however, that a sulfur crosslinker is used to manufacture NBR, which is incompatible with fluorosilicone curing. This is because a platinum catalyst is used during fluorosilicone curing and small (parts per billions) levels of sulfur can poison these catalysts. *See* "Platinum Catalysts Used in the Silicones Industry", Lewis et. al., Platinum Metals Rev., 1997,41, (2), 66-75. In view of the foregoing, the present inventors designed carcasses based on sulfur-free elastomer, e.g., a fluorosilicone elastomer. Such novel carcasses are not only compatible with flurosilicone curing chemistry, for example, but are resistant to coating solvents and able to withstand harsh curing conditions, such as 160°C temperatures for extended time periods. Accordingly, the present blanket configuration including sulfur-free carcasses may be used with desirable surface layers that include fluoropolymers, such as fluorosilicone. In an embodiment, the carcass does not contain more than trace amounts of sulfur, such as less than 0.2% by weight, such as, for example, between 0.2% and 0% by weight, such as about 0.1% to 0% by weight, such as about 0.02% to 0% by weight, or about 0.001% to 0% by weight of sulfur, as determined by XPS (X-ray photoelectron spectroscopy).. In an embodiment, the carcass is entirely free of sulfur.

An embodiment of the present disclosure is directed to an imaging blanket for variable data lithography. The imaging blanket comprises a substrate. A foam layer is disposed on the substrate. An elastomeric layer is disposed on the foam layer, the elastomeric layer comprising a silicone elastomer. The elastomeric layer has a Shore A hardness ranging from about 50 Shore A to about 100 Shore A.

In certain embodiments, the at least one thermally-conductive filler is present in the elastomeric layer in an amount ranging from about 1% to about 15% by weight, such as about 1% to about 10% or about 2% to about 5%, based on the total weight of the elastomeric layer, and in certain embodiments, the silicone elastomer is present in the elastomeric layer in an amount ranging from about 85% to about 99% by weight, such as about 90% to about 99% or about 95% to about 98%, based on the total weight of the elastomeric layer.

In certain embodiments, the elastomeric layer further comprises at least one catalyst, such as platinum, and in certain embodiments, the silicone elastomer is a room temperature vulcanization silicone rubber.

In certain embodiments, the elastomeric layer disposed on the substrate consists of a silicone elastomer, at least one thermally-conductive filler, and a catalyst.

In certain embodiments of the imaging blankets disclosed herein, the substrate comprises at least one material selected from the group consisting of metals, plastics, such as polyimides, and woven fabrics. In an embodiment, the substrate is rigid, such as a rigid sleeve. In an embodiment, the substrate is a rigid sleeve comprising metal, plastic or both. In an embodiment, the substrate and the imaging blanket do not include a fabric layer.

In further embodiments disclosed herein, the imaging blanket comprises a top coat comprising fluorosilicone and at least one infrared-absorbing filler, such as carbon black.

In various embodiments of the disclosure, the elastomeric layer has a Shore A hardness ranging from about 60 Shore A to about 80 Shore A. In certain embodiments, a temperature of the imaging blanket does not increase more than about 5 °C, such as more than about 3 °C, after about 20, about 30, about 40, or about 50 revolutions of the imaging blanket during printing. In certain embodiments, the temperature of the imaging blanket is below about 28 °C, such as below about 27 °C, below 26 °C, or below about 25 °C, after about 20, about 30, about 40, or about 50 revolutions of the imaging blanket during printing.

An embodiment of the present disclosure is directed to a method of making an imaging blanket for variable data lithography. The method comprises providing a substrate having a foam layer disposed thereon. An elastomeric layer comprising a silicone elastomer is applied to the foam layer. The elastomeric layer is cured. The elastomeric layer has a Shore A hardness ranging from about 50 Shore A to about 100 Shore A.

Yet another embodiment of the present disclosure is directed to a variable data lithography system. The system comprises an imaging member comprising an imaging blanket. The imaging blanket comprises a substrate. A foam layer is disposed on the substrate. An elastomeric layer is disposed on the foam layer. The elastomeric layer comprises a silicone elastomer. The imaging blanket further comprises a top coat comprising fluorosilicone and at least one infrared-absorbing filler. The variable data lithography system further comprises a fountain solution subsystem configured for applying a layer of fountain solution to the imaging blanket; a patterning subsystem configured for selectively removing portions of the fountain solution layer so as to produce a latent image; an inker subsystem configured for applying ink over the imaging blanket to thereby produce an ink image; and an image transfer mechanism configured for transferring the ink image to a media substrate.

### BRIEF DESCRIPTION OF THE DRAWINGS

The accompanying drawings, which are incorporated in and constitute a part of this specification, illustrate embodiments of the present teachings and together with the description, serve to explain the principles of the present teachings.
FIG. 1 is a schematic drawing of a variable data lithography system according to various embodiments disclosed herein.
FIG. 2 is a schematic side view of a multilayer imaging blanket, according to various embodiments disclosed herein.
FIG. 3 is a schematic side view of a multilayer imaging blanket, according to various additional embodiments disclosed herein.
FIG. 4 shows an example of a fluorosilicone compound and a reaction for forming the compound.
FIG. 5 shows a print from a silicone based carcass showing excellent print IQ, according to and example of the present disclosure.

It should be noted that some details of the figures may have been simplified and are shown to facilitate understanding of the embodiments rather than to maintain strict structural accuracy, detail, and scale.

### DESCRIPTION OF THE EMBODIMENTS

Reference will now be made in detail to embodiments of the present disclosure. The following description is merely exemplary.

In the following description, reference is made to the accompanying drawings that form a part thereof, and in which is shown by way of illustration specific exemplary embodiments in which the present teachings may be practiced. These embodiments are described in sufficient detail to enable those skilled in the art to practice the present teachings and it is to be understood that other embodiments may be utilized and that changes may be made without departing from the scope of the present teachings. The following description is, therefore, merely illustrative.

Although embodiments of the disclosure herein are not limited in this regard, the terms "plurality" and "a plurality" as used herein may include, for example, "multiple" or "two or more." The terms "plurality" or "a plurality" may be used throughout the specification to describe two or more components, devices, elements, units, parameters, or the like. For example, "a plurality of resistors" may include two or more resistors.

As used herein, the term "polyorganosiloxane" is used interchangeably with "siloxane," "silicone," "silicone oil," and "silicone rubber." Polyorganosiloxanes are well-understood to those of skill in the relevant art to refer to siloxanes having a backbone formed from silicon and oxygen atoms and sidechains containing carbon and hydrogen atoms. As used herein, the term "silicone" should also be understood to exclude siloxanes that contain fluorine atoms, while the term "fluorosilicone" is used to cover the class of siloxanes that contain fluorine atoms. Other atoms may be present in the silicone, for example, nitrogen atoms in amine groups which are used to link siloxane chains together during crosslinking.

The term "fluorosilicone" as used herein refers to polyorganosiloxanes having a backbone formed from silicon and oxygen atoms, and sidechains containing carbon, hydrogen, and fluorine atoms. At least one fluorine atom is present in the sidechain. The sidechains can be linear, branched, cyclic, or aromatic. The fluorosilicone may also contain functional groups, such as amino groups, which permit addition cross-linking. When the cross-linking is complete, such groups become part of the backbone of the overall fluorosilicone. The side chains of the polyorganosiloxane can also be alkyl or aryl. Fluorosilicones are commercially available, for example CFl-3510 from NuSil® or SLM (n-27) from Wacker.

The terms "media substrate," "print substrate," and "print media" generally refer to a usually flexible physical sheet of paper, polymer, Mylar® material, plastic, or other suitable physical print media substrate, sheets, webs, etc., for images, whether precut or web fed.

The term "printing device" or "printing system" as used herein refers to a digital copier or printer, scanner, image printing machine, xerographic device, electrostatographic device, digital production press, document processing system, image reproduction machine, bookmaking machine, facsimile machine, multi-function machine, or generally an apparatus useful in performing a print process or the like and can include several marking engines, feed mechanism, scanning assembly as well as other print media processing units, such as paper feeders, finishers, and the like. A "printing system" may handle sheets, webs, substrates, and the like. A printing system can place marks on any surface, and the like, and is any machine that reads marks on input sheets; or any combination of such machines.

As used herein, the term "ink-based digital printing" is used interchangeably with "variable data lithography printing" and "digital offset printing," and refers to lithographic printing of variable image data for producing images on a substrate that are changeable with each subsequent rendering of an image on the substrate in an image forming process. As used herein, "ink-based digital printing" includes offset printing of ink images using lithographic ink where the images are based on digital image data that may vary from image to image. As used herein, the ink-based digital printing may use a "digital architecture for lithographic ink" (DALI) or a variable data lithography printing system or a digital offset printing system, where the system is configured for lithographic printing using lithographic inks and based on digital image data, which may vary from one image to the next. As used herein, an ink-based digital printing system using DALI may be referred as a DALI printer. As used herein, an imaging member of a DALI printer may be referred to interchangeably as a DALI printing plate and a DALI imaging blanket.

All physical properties that are defined hereinafter are measured at 20 °C to 25 °C unless otherwise specified. The term "room temperature" refers to a temperature ranging from about 20 °C to about 25 °C, such as about 25 °C, unless otherwise specified.

Many of the examples mentioned herein are directed to an imaging blanket (including, for example, a printing sleeve, belt, imaging blanket employed on a drum, and the like) that has a uniformly grained and textured blanket surface that is ink-patterned for printing. Further examples of variable data lithographic printing are disclosed in U.S. Patent Application Publication No. 2012/0103212 A1 (the '212 publication) published May 3, 2012, and based on U.S. patent application Ser. No. 13/095,714, and the disclosure of which is hereby incorporated by reference herein in its entirety. The text recited directly in the present application takes precedence over any conflicting statements made in any subject matter incorporated herein by reference.

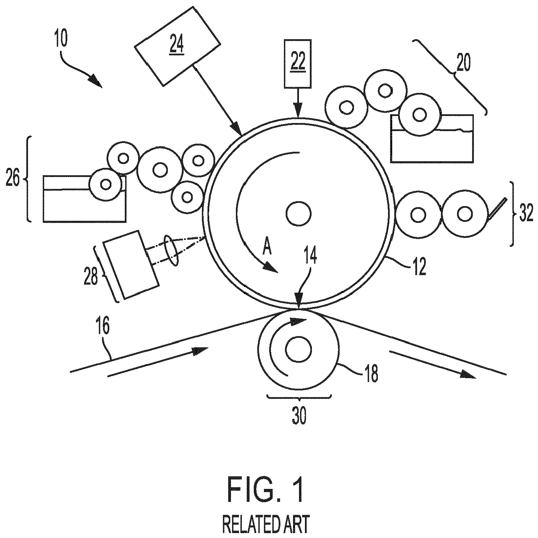

FIG. 1 depicts an exemplary variable data lithography printing system 10. A general description of the exemplary system 10 shown in FIG. 1 is provided here. Additional details regarding individual components and/or subsystems shown in the exemplary system 10 of FIG. 1 may be found in the '212 publication. As shown in FIG. 1, the exemplary system 10 may include an imaging member 12 used to apply an inked image to a target image receiving media substrate 16 at a transfer nip 14. The transfer nip 14 is produced by an impression roller 18, as part of an image transfer mechanism 30, exerting pressure in the direction of the imaging member 12.

The imaging member 12 may include a reimageable surface layer (imaging blanket layer or carcass) formed over a structural mounting layer that may be, for example, a cylindrical core, or one or more structural layers over a cylindrical core. A fountain solution subsystem 20 may be provided generally comprising a series of rollers, which may be considered as dampening rollers or a dampening unit, for uniformly wetting the reimageable surface with a layer of dampening fluid or fountain solution, generally having a uniform thickness, to the reimageable surface of the imaging member 12. Once the dampening fluid or fountain solution is metered onto the reimageable surface, a thickness of the layer of dampening fluid or fountain solution may be measured using a sensor 22 that provides feedback to control the metering of the dampening fluid or fountain solution onto the reimageable surface.

An optical patterning subsystem 24 may be used to selectively form a latent image in the uniform fountain solution layer by image-wise patterning the fountain solution layer using, for example, laser energy. It is advantageous to form the reimageable surface of the imaging member 12 from materials that should ideally absorb most of the infrared or laser energy emitted from the optical patterning subsystem 24 close to the reimageable surface. Forming the surface of such materials may advantageously aid in substantially minimizing energy wasted in heating the fountain solution and coincidentally minimizing lateral spreading of heat in order to maintain a high spatial resolution capability. Briefly, the application of optical patterning energy from the optical patterning subsystem 24 results in selective evaporation of portions of the uniform layer of fountain solution in a manner that produces a latent image.

The patterned layer of fountain solution having a latent image over the reimageable surface of the imaging member 12 is then presented or introduced to an inker subsystem 26. The inker subsystem 26 is usable to apply a uniform layer of ink over the patterned layer of fountain solution and the reimageable surface of the imaging member 12. In embodiments, the inker subsystem 26 may use an anilox roller to meter an ink onto one or more ink forming rollers that are in contact with the reimageable surface of the imaging member 12. In other embodiments, the inker subsystem 26 may include other traditional elements such as a series of metering rollers to provide a precise feed rate of ink to the reimageable surface. Ink from the inker subsystem 26 may adhere to the areas of the reimageable surface that do not have fountain solution thereon to form an ink image, while ink deposited on the areas of the reimageable surface on which the fountain solution layer remains will not adhere to the reimageable surface.

Cohesiveness and viscosity of the ink residing on the reimageable surface may be modified by a number of mechanisms, including through the use of some manner of rheology control subsystem 28. In embodiments, the rheology control subsystem 28 may form a partial cross-linking core of the ink on the reimageable surface to, for example, increase ink cohesive strength relative to an adhesive strength of the ink to the reimageable surface. In embodiments, certain curing mechanisms may be employed. These curing mechanisms may include, for example, optical or photo curing, heat curing, drying, or various forms of chemical curing. Cooling may be used to modify rheology of the transferred ink as well via multiple physical, mechanical or chemical cooling mechanisms.

Substrate marking occurs as the ink is transferred from the reimageable surface of imaging member 12 to media substrate 16 using the transfer subsystem 30. With the adhesion and/or cohesion of the ink having been modified by the rheology control system 28, modified adhesion and/or cohesion of the ink causes the ink to transfer substantially completely, preferentially adhering to the media substrate 16 as it separates from the reimageable surface of the imaging member 12 at the transfer nip 14. Careful control of the temperature and pressure conditions at the transfer nip 14, among other things, may allow transfer efficiencies for the ink from the reimageable surface of the imaging member 12 to the media substrate 16 to exceed, for example, 95%. While it is possible that some fountain solution may also wet substrate 16, the volume of such transferred fountain solution will generally be minimal so as to rapidly evaporate or otherwise be absorbed by the substrate 16.

Finally, a cleaning system 32 is provided to remove residual products, including non-transferred residual ink and/or remaining fountain solution from the reimageable surface in a manner that is intended to prepare and condition the reimageable surface of the imaging member 12 to repeat the above cycle for image transfer. An air knife may be employed to remove residual fountain solution. It is anticipated, however, that some amount of ink residue may remain. Removal of such remaining ink residue may be accomplished by cleaning subsystem 32. The cleaning subsystem 32 may include, for example, at least a first cleaning member, such as a sticky or tacky member, in physical contact with the reimageable surface of the imaging member 12, where the sticky or tacky member removes residual ink and any remaining small amounts of surfactant compounds from the fountain solution of the reimageable surface of the imaging member 12. The sticky or tacky member may then be brought into contact with a smooth roller to which residual ink may be transferred from the sticky or tacky member, the ink being subsequently stripped from the smooth roller by, for example, a doctor blade. Any other suitable cleaning system can be employed.

Regardless of the type of cleaning system used, cleaning of the residual ink and fountain solution from the reimageable surface of the imaging member 12 can prevent or reduce the risk of a residual image from being printed in the proposed system. Once cleaned, the reimageable surface of the imaging member 12 is again presented to the fountain solution subsystem 20 by which a fresh layer of fountain solution is supplied to the reimageable surface of the imaging member 12, and the process is repeated.

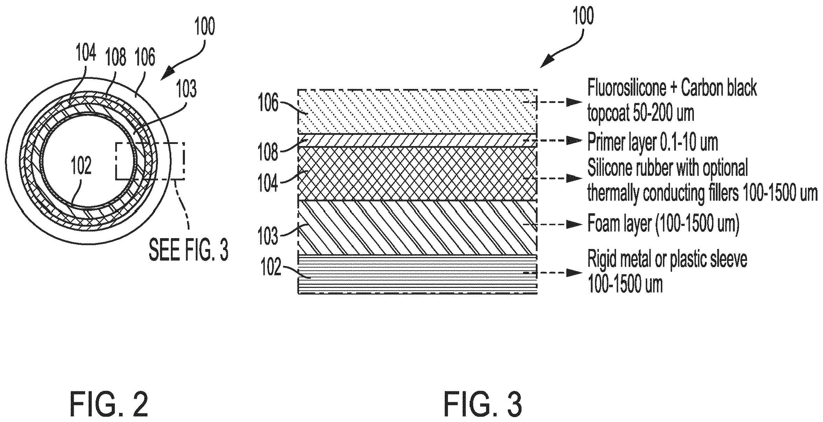

FIG. 2 illustrates a schematic side view of an imaging blanket 100 for use with an imaging member, such as, for example, as part of imaging member 12. FIG. 3 illustrates an enlarged view of a portion of the imaging blanket 100 of FIG. 2. Imaging member 12 can be in the form of, for example, a printing cylinder or drum on which the imaging blanket 100 is inserted as part of a printing sleeve. Printing sleeves and printing cylinders or drums are generally well known in the art.

Imaging blanket 100 comprises a substrate 102. A foam layer 103 is disposed on substrate 102. An elastomeric layer 104 is disposed on the foam layer 103. In an embodiment, the elastomeric layer 104, foam layer 103 and substrate 102 can form a seamless carcass on which a top coat 106 can be subsequently formed. In an embodiment, the top coat 106 comprises an elastomer and a platinum catalyst. An optional primer layer 108 can be disposed between the elastomeric layer 104 and the top coat 106. In an embodiment, the top coat 106 is the topmost surface layer. In an alternative embodiment, the topcoat layer 106 is not formed and the elastomeric layer 104, foam layer 103 and substrate 102 together form a carcass, for which the elastomeric layer 104 is the topmost surface layer. The carcass can be sold or supplied without the top coat layer 106, although the carcass may subsequently be used as a substrate on which to deposit additional layers, such as topcoat layer 106.

The term "on" as used herein is defined broadly to include both "directly on" and "indirectly on". Thus, for example, the phrase "top coat 106 is disposed on elastomeric layer 104" is broad enough to include intervening layers, such as primer layer 108, formed between the top coat 106 and the elastomeric layer 104, as well as the case where the top coat 106 is disposed directly on the elastomeric layer 104. The term "directly on" is defined to mean "in direct physical contact with". Additionally, it is contemplated that each instance of "on" in this application can encompass embodiments where both direct physical contact does or does not occur. Further, in is contemplated that all instances of the term "on" herein can be replaced with "directly on" in the event that it is desired to convey the meaning that direct physical contact occurs, such as for purposes of narrowing a claim.

The substrate 102 can be in the form of a roll (e.g., such as a sleeve), belt, or plates mounted to a roll, as is well-known in the art. FIG. 2 illustrates the substrate 102 in the form of a sleeve. The substrate 102 can be made of any suitable material, such as, for example, polymers such as polyimide; silicone or biaxially-oriented polyethylene terephthalate (e.g., Mylar®); metals such as nickel, aluminum, or aluminum alloys; woven fabric; quartz; plastic composites; or combinations thereof. In an embodiment, the substrate is rigid, such as a rigid sleeve. In an embodiment, the substrate is a rigid sleeve comprising metal, plastic or both. The substrate can optionally include multiple layers, such as one or more additional layers on the rigid sleeve (e.g., one or more polymer, woven fabric or other layers). In an embodiment, the substrate and the resulting imaging member do not include a fabric layer, such as a woven fabric.

Any suitable substrate thickness can be chosen. In an embodiment, the thickness of substrate 102 may range, for example, from about 10 microns to about 10 mm, such as about 100 microns to about 3000 microns, or about 100 microns to about 1500 microns.

Referring to FIGS. 2 and 3, the foam layer 103 is employed to provide improved compliance of the imaging blanket 100 with the inking roller. The material employed for the foam layer can be any suitable foam that provides the desired compliance, as well as durability, thermal-conductivity and adherence to the imaging blanket, and that is otherwise consistent with the imaging blanket functions. As an example, foam layer 103 comprises a silicone foam, such as a closed cell silicone foam. The amount of silicone foam can be present in the elastomeric layer 104 in any desired amount sufficient so as to provide the desired properties, such as thermal-conductivity or hardness or compliance. For example, the foam layer 103 can comprises about 85% to about 100%, or about 90% to about 99% or about 95% to about 98%, foam material, such as any of the silicone foams described herein. The foam layer 103 may optionally include thermally conductive fillers dispersed within the silicone foam. Any of the thermally conductive fillers disclosed herein can be employed in the foam layer 103. In certain embodiments, at least one thermally-conductive filler may be present in the foam layer in an amount ranging from about 1% to about 15% by weight of the total weight of the foam layer composition, such as from about 1% to 10% or about 2% to about 5%. The silicone foam layer can have Shore A durometer hardness of from about 10 to about 50 Shore A.

The top coat 106 comprises an elastomer, such as a fluorosilicone elastomer. In an embodiment, the fluorosilicone elastomer is cured using a platinum catalyst. After curing, the platinum catalyst remains as a part of the top coat 106. Examples of suitable fluorosilicone elastomers are described in greater detail below.

The top coat 106 optionally further includes an infrared absorbing material. The infrared-absorbing filler is able to absorb energy from the infra-red portion of the spectrum (having a wavelength of from about 750 nm to about 1000 nm). This may aid in efficient evaporation of a fountain solution. In certain embodiments, the at least
one infrared-absorbing filler may be chosen from carbon black, a metal oxide such as iron oxide, carbon nanotubes, graphene, graphite, or carbon fibers. The at least one infrared-absorbing filler may have an average particle size of from about 2 nanometers to about 10 microns. In an embodiment, the IR absorbing filler may have an average particle size of from about 20 nm to about 5 µm. In certain embodiments, the at least one infrared-absorbing filler may be present in the top coat composition in an amount ranging from about 5% to about 20% by weight based on the total weight of the top coat composition, such as from about 7% to about 17% or from about 10% to about 15%.

In embodiments, the IR absorbing filler is carbon black. In an embodiment, the IR absorbing filler is a low-sulphur carbon black, such as Emperor 1600 (available from Cabot). In an embodiment, a sulphur content of the carbon black is 0.3% or less. In an embodiment, the sulphur content of the carbon black is 0.15% or less.

In an embodiment, the top coat 106 may comprise additional ingredients in addition to the fluorosilicone and the at least one infrared-absorbing filler, such as, for example, additional fillers. In certain embodiments, an additional filler may be silica. Silica can help increase the tensile strength of the top coat and increase wear resistance. Silica may be present in an amount ranging from about 1% to about 30% by weight based on the total weight of the top coat 106, such as from about 1% to about 5%, about 5% to about 30%, or from about 10% to about 25%. The weight percentages of ingredients for the elastomeric layer, top coat and other layers are based on total dry weight of the deposited composition used to make the particular layer prior to any curing, unless stated otherwise. The silica may have an average particle size ranging from about 10 nm to about 0.2 µm, such as from about 50 nm to about 0.1 µm or about 20 nm.

The top coat may have a thickness ranging, for example, from about 0.5 µm to about 4 mm, depending on the requirements of the overall printing system. In an embodiment, the top coat 106 may have a thickness of about 10 microns (µm) to about 1 millimeter (mm). In other embodiments, the imaging member top coat has a thickness of about 20 µm to about 200 µm, or about 50 µm to about 200 µm. In one embodiment, the thickness of the top coat is of about 40 µm to about 60 µm. In another embodiment, the thickness of the top coat is of about 80 µm to about 150 µm

In an embodiment, the top coat 106 may have a surface energy of 22 dynes/cm or less with a polar component of 5 dynes/cm or less. In other embodiments, the top coat has a surface energy of 21 dynes/cm or less with a polar component of 2 dynes/cm or less or a surface energy of 19 dynes/cm or less with a polar component of 1 dyne/cm or less.

In an embodiment, the top coat 106, as illustrated in both FIGS. 2 and 3, comprises fluorosilicone materials manufactured from a first part and a second part. The first part (Part A) may include fluorosilicone, an IR absorbing filler, silica and a solvent. The second part (Part B) may include a platinum catalyst having vinyl groups, a cross-linker having hydrosilane groups, a solvent and an inhibitor. The molar ratio of vinyl groups to hydrosilane groups in Part B is, for example, about 1:1.

The fluorosilicone of part A may include a vinyl terminated trifluoropropyl methylsiloxane polymer (e.g., Wacker 50330, SML (n=27)) and is illustrated below in Formula 1. 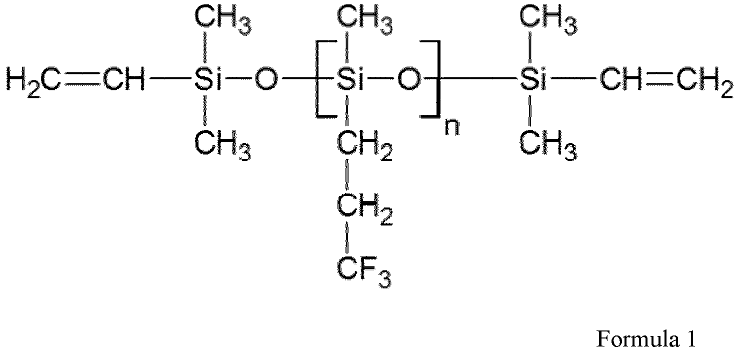 where n can be in range from 10 to 100, or from 15 to 90 or from 18 to 80.

In embodiments, the IR absorbing filler of Part A may be any of the IR absorbing fillers described herein. In embodiments, the IR absorbing filler is carbon black. In an embodiment, the IR absorbing filler is a low-sulphur carbon black, such as those described herein.

In embodiments, the Part A includes silica. As examples, any of the silica particles described herein can be employed in any of the amounts described herein.

In embodiments, the solvent of Part A may be butyl acetate, trifluorotoluene, toluene, benzene, methylethylketone, methyl isobutyl ketone, ethyl acetate, propyl acetate, amyl acetate, hexyl acetate and mixtures thereof. Any other suitable solvents, such as those compatible with the materials (e.g., the elastomeric layer 104 and/or primer 108) and process procedures and chemistry for making the topcoat 106 can be employed in addition to, or in place of, these solvents.

Part B may include a platinum catalyst having vinyl groups. An example of a platinum (Pt) catalyst is illustrated in Formula 2 below. 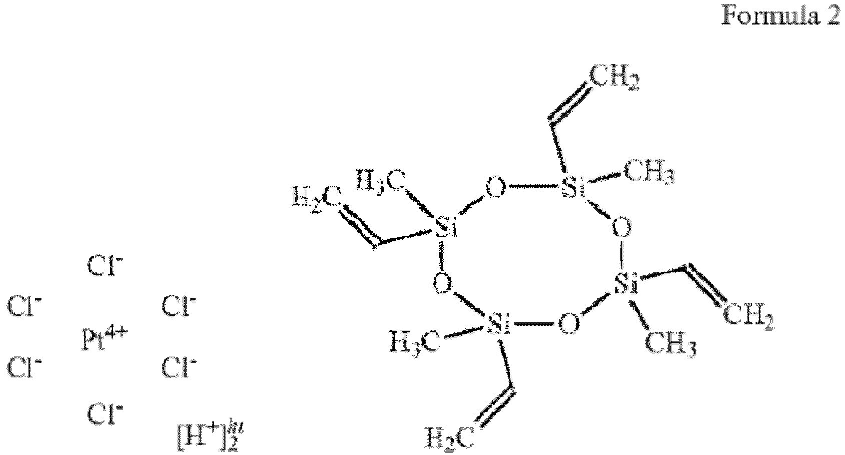 As shown in Formula 2, the platinum catalyst has vinyl groups.

Part B includes a cross-linker (e.g., trifluoropropyl methylsiloxane polymer having hydrosilane groups). In some embodiments, the top coat composition includes fluorosilicone cross-linker. In one embodiment, the cross-linker is a XL-150 cross-linker from NuSil Corporation. In one embodiment, the cross-linker is a SLM 50336 cross-linker from Wacker. For example, in one embodiment, the top coat composition includes between 10 weight percent and 28 weight percent of a cross-linker based on the total weight of the top coat composition. In another embodiment, the top coat includes between 12 weight percent and 20 weight percent cross-linker. In yet another embodiment, the top coat includes about 15 weight percent cross-linker based on the total weight of the top coat composition.

A cross-linker having hydrosilane groups is illustrated in Formula 3 below. 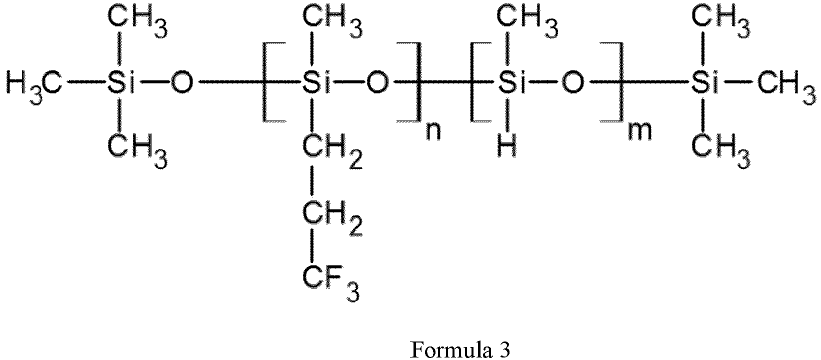 As shown in Formula 3, the cross-linker has hydrosilane groups. In Formula 3, n is from 10 to 100, or n is from 15 to 90, or n is from 18 to 80; and m is from 1 to 50, or m is from 2 to 45 or m is from 3 to 40. The molar ratio of vinyl groups in Part A to hydrosilane groups in the cross-linker in Part B is 0.7:1.0 to about 1.3:1.0, or a molar ratio of from 0.8:1.0 to about 1.2:1.0, or the molar ratio is from about 0.9:1.0 to about 1.1:1.0.

The inhibitor (e.g., pt88) may be used in the solution to increase the pot life of the combined solution of Part A and Part B for flow coating.

In embodiments, the solvent of Part B may be butyl acetate, trifluorotoluene, toluene, benzene, methylethylketone, methyl isobutyl ketone, ethyl acetate, propyl acetate, amyl acetate, hexyl acetate and mixtures thereof. Any other suitable solvents, such as those compatible with the materials (e.g., the elastomeric layer 104) and process procedures and chemistry for making the topcoat 106 can be employed in addition to, or in place of, these solvents.

The top coat 106 (FIG. 2 or FIG. 3) may be coated on the elastomeric layer 104 of the carcass using any suitable techniques. For example, in one embodiment, the method includes depositing a fluorosilicone top coat composition by flow coating, ribbon coating or dip coating; and curing the top coat at an elevated temperature.

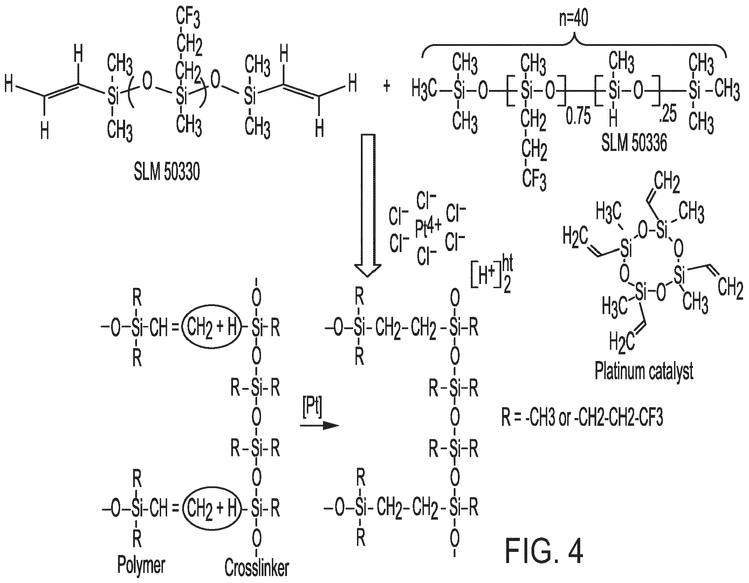

In embodiments, the platinum catalyst is added to Part A followed by gentle shaking. Then Part B is added to the Part A solution containing Pt catalyst followed by 5 min of ball milling. The total solid content can be controlled by dilution with additional amount of, for example, butyl acetate. The dispersion can be filtered to remove the stainless steel beads, followed by degassing of the filtered dispersion. The dispersion may then be coated over the carcass and primer layer. The dispersion may also be molded. The curing may be performed at an elevated temperature for a desired time, such as any of the temperature ranges and time periods described herein for curing the top coat 106. An example of a fluorosilicone compound and an example reaction for forming the compound is shown in FIG. 4.

An optional primer layer 108 can comprise any suitable material that improves the adhesion between the layers. An example of a primer material is siloxane. In an embodiment, primer layer 108 comprises octamethyl trisiloxane (e.g., S11 NC commercially available from Henkel). In another example, the primer material includes vinyl terminated alkoxysilane, such as Wacker G790 primer. In addition an inline corona treatment can be applied to the substrate 102 and/or primer layer 108 for further improved adhesion, as readily understood by a skilled artisan. Such inline corona treatments may increase the surface energy and adhesion of the imaging blanket layers. The primer layer thickness can range from about 0.01 micron to about 20 microns, such as about 0.1 micron to about 15 microns, or about 0.1 microns to about 10 microns.

The elastomeric layer 104 comprises a silicone elastomer. The silicone elastomer may be any known silicone elastomer. For example, in certain embodiments the silicone elastomer may be a silicone rubber, such as room temperature vulcanization (RTV) silicone rubbers, high temperature vulcanization (HTV) silicone rubbers, and low temperature vulcanization (LTV) silicone rubbers. Such rubbers are known and readily available commercially, such as, for example, RT 622 silicone from Wacker Chemical Corporation; Silastic® 735 black RTV and Silastic® 732 RTV, both from Dow Corning; 106 RTV Silicone Rubber and 90 RTV Silicone Rubber, both from General Electric; and JCR6115Clear HTV and SE4705U HTV silicone rubbers, both from Dow Corning Toray Silicones. In certain embodiments, the silicone elastomer is an RTV silicone rubber. The silicone elastomer may be present in the elastomeric layer 104 in any desired amount sufficient so as to provide the desired properties, such as thermal-conductivity or hardness. For example, in certain embodiments, the silicone elastomer is present in the elastomeric layer in an amount ranging from about 85% to about 100% by weight, such as about 90% to about 99% or about 95% to about 98%.

The elastomeric layer can optionally include at least one thermally conductive filler. In embodiments, the at least one thermally-conductive filler may be chosen from metal oxides, such as iron oxide, aluminum oxide, magnesium oxide, zirconium oxide, and zinc oxide; aluminum nitride; boron nitride; carbon black; carbon nanotubes graphene; and mixtures thereof (the concept of "mixtures thereof' is encompassed by the phrase "at least one" as recited throughout this application). In certain embodiments, the at least one thermally-conductive filler is chosen from aluminum oxide and boron nitride. In certain embodiments, the at least one thermally-conductive filler is chosen from iron oxide and aluminum oxide.

The filler may be included in an amount sufficient to enhance thermal conductivity and, when coated on a substrate, may provide an imaging blanket having enhanced thermal conductivity. In certain embodiments, the at least one thermally-conductive filler may be present in the composition in an amount ranging from about 1% to about 15% by weight of the total weight of the silicone elastomer composition, such as from about 1% to 10% or about 2% to about 5%.

Further disclosed herein is a method of making an imaging blanket. In certain embodiments, the method comprises coating the silicone elastomer disclosed herein on a substrate to form the imaging blanket. The substrate can be any substrate disclosed herein, such as substrates 102, described above. The silicone elastomer disclosed herein may be coated on the substrate by any method known in the art, such as by flow coating, dip coating or ribbon flow coating. After coating, the silicone elastomer may be cured on the substrate. In embodiments, the composition is cured at a temperature ranging from about 20 °C to about 250 °C, such as, or about 100 °C to about 200 °C. In an embodiment, the composition is cured on the substrate at room temperature, such as about 20 °C to about 25 °C. In certain embodiments, the silicone elastomer disclosed herein may be cured by the addition of at least one catalyst and/or initiator, such as a platinum catalyst, a tin catalyst, a peroxide catalyst or initiator, or any combination of two or more of any of the listed catalysts and/or initiators.

The silicone elastomer disclosed herein may be coated on the substrate in any thickness appropriate for the desired application, such as a variable data lithography printing application. In certain embodiments, the thickness of the elastomeric layer on the substrate may range from about 0.1 mm to about 1.5 mm, such as from about 0.25 mm to about 1.0 mm, about 0.5 mm to about 0.75 mm, or, in certain embodiments, a thickness of about 0.5 mm.

As disclosed herein, the imaging blankets coated with the silicone elastomer disclosed herein may demonstrate enhanced thermal conductivity. This enhanced thermal conductivity may be observed even though the imaging blanket maintains a desired hardness. For example, in certain embodiments, the Shore A hardness of the elastomeric layer 104 disclosed herein may range from about 50 Shore A to about 100 Shore A, such as from about 60 Shore A to about 90 Shore A or from about 60 Shore A to about 80 Shore A. The hardness of the silicone elastomer composition may be measured by any means known in the art, such as with a Shore A durometer dial.

In certain exemplary embodiments, the thermal conductivity of the elastomeric layer or the imaging blanket that has been coated with the elastomeric layer as disclosed herein may range from about 0.5 W/m² to about 10 W/m², such as from about 0.5 W/m² to about 5 W/m² or from about 0.6 W/m² to about 1.6 W/m². Thermal conductivity may be measured by any means known in the art. For example, in certain embodiments, thermal conductivity may be measured using the flash method, wherein a sample may be heated by a short light pulse and the resulting temperature increase measured using an infrared detector. In certain embodiments, thermal conductivity may be measured using, for example, an LFA 447 NanoFlash® from Netzsch Group.

In embodiments, as described above, the imaging blanket disclosed herein that has been coated with an elastomeric layer may further comprise a top coat, for example a dispersion comprising fluorosilicone and optionally at least one infrared-absorbing filler and/or additional filler, such as top coat 106.

In certain embodiments, the top coat composition may be applied to the imaging blanket coated with the elastomeric layer 104 disclosed herein and then cured. The curing may be performed at an elevated temperature, such as a temperature ranging from about 135 °C to about 165 °C, such as about 160 °C. This elevated temperature is in contrast to room temperature. The curing may occur for a time period of from about 15 minutes to about 5 hours, such as about 1 hour to about 4 hours or from about 2 hours to about 4 hours. In certain embodiments, the curing may occur at about 160 °C for about 4 hours. The top coat composition may further comprise a catalyst, such as a platinum catalyst or any of the other catalysts disclosed herein for use in depositing the top coat.

In certain embodiments disclosed herein, the imaging blanket comprising an elastomeric layer may have improved thermal conductivity when compared to a traditional imaging blanket, such as an imaging blanket comprising fabric layers and one or both of compressible foam layers and rubber layers, where the compressible foam and rubber layers do not include a thermally conductive filler. In certain embodiments, the imaging blanket as disclosed herein may show improved thermal conductivity in that during printing, after at least about 10 revolutions, such as after at least about 20 revolutions, at least about 30 revolutions, at least about 40 revolutions, or at least about 50 revolutions, the imaging blanket has a temperature of less than about 29 °C, such as less than about 28 °C, less than about 27 °C, less than about 26 °C, or less than about 25 °C, such as a between about 24 °C and about 25 °C. In certain embodiments, the imaging blanket as disclosed herein may show improved thermal conductivity in that during printing after at least about 10 revolutions, such as after at least about 20 revolutions, at least about 30 revolutions, at least about 40 revolutions, or at least about 50 revolutions, the imaging blanket increases in temperature from its starting temperature (i.e., 0 revolutions) by less than about 9 °C, such as less than about 8 °C, less than about 7 °C, less than about 6 °C, less than about 5 °C, less than about 4 °C, less than about 3 °C, or by about 3 °C.

Further disclosed herein are processes for variable data lithographic printing. In certain embodiments, the process comprises applying a fountain solution to an imaging member comprising an elastomeric layer as disclosed herein; evaporating the fountain solution from selective locations on the imaging member surface to form non-image areas and image areas, which form a latent image; developing the latent image by applying an ink composition to the image areas; and transferring the developed latent image to a receiving substrate. The imaging blanket may be any of the imaging blankets described herein.

Notwithstanding that the numerical ranges and parameters setting forth the broad scope of the disclosure are approximations, the numerical values set forth in the specific examples are reported as precisely as possible. Any numerical value, however, inherently contains certain errors necessarily resulting from the standard deviation found in their respective testing measurements. Moreover, all ranges disclosed herein are to be understood to encompass any and all sub-ranges subsumed therein.

While the present teachings have been illustrated with respect to one or more implementations, alterations and/or modifications can be made to the illustrated examples without departing from the spirit and scope of the appended claims. In addition, while a particular feature of the present teachings may have been disclosed with respect to only one of several implementations, such feature may be combined with one or more other features of the other implementations as may be desired and advantageous for any given or particular function. Furthermore, to the extent that the terms "including," "includes," "having," "has," "with," or variants thereof are used in either the detailed description and the claims, such terms are intended to be inclusive in a manner similar to the term "comprising." Further, in the discussion and claims herein, the term "about" indicates that the value listed may be somewhat altered, as long as the alteration does not result in nonconformance of the process or structure to the illustrated embodiment. Finally, "exemplary" indicates the description is used as an example, rather than implying that it is an ideal.

It will be appreciated that variants of the above-disclosed and other features and functions, or alternatives thereof, may be combined into many other different systems or applications. Various presently unforeseen or unanticipated alternatives, modifications, variations, or improvements therein may be subsequently made by those skilled in the art which are also intended to be encompasses by the following claims.

### EXAMPLES

The following Examples are being submitted to further define various species of the present disclosure. These Examples are intended to be illustrative only and are not intended to limit the scope of the present disclosure. Parts and percentages are by weight unless otherwise indicated.

### Example 1

A test carcass was made comprising a silicone elastomer and a silicone foam. The carcass was constructed by first disposing a closed cell silicone foam layer on a Nickle metal sleeve. The thickness of the foam layer was 300 microns with Shore A hardness of 25. Then thermally-conductive fillers were dispersed into a room-temperature polydimethylsiloxane-based vulcanizing RTV silicone formulation, and the resulting dispersion was coated onto the existing nickel sleeve with the foam layer and cured using a platinum catalyst at range of about 100 °C to about 200 °C for 1-4 hours to yield the carcass. The thickness of the layer of silicone elastomer with thermally-conductive fillers cured on the sleeve was 500 microns, and it was measured to have a Shore A hardness of 80 Shore A, with a thermal conductivity of about 0.78 W/m². Shore hardness was measured using a Shore Dial Durometer from Instron®.

### Example 2

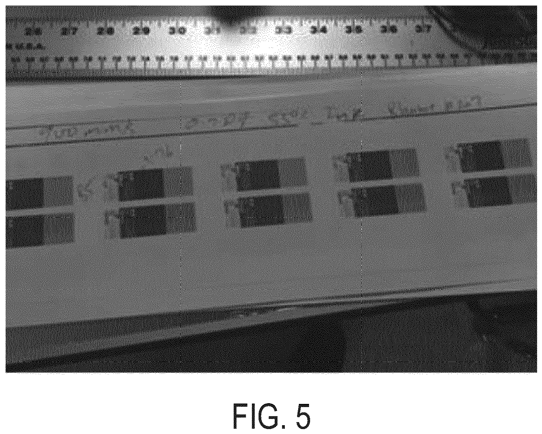

The fluorosilicone/carbon black topcoat was applied by inverse ring coating to the seamless silicone/silicone foam test carcass described above in Example 1. A G790 primer layer was deposited on the carcass prior to depositing the topcoat. The topcoat was cured at 160°C for 4 hours. The topcoat cured completely. The topcoat had good adhesion with the silicone with a G790 primer from Wacker, which is a vinyl terminated alkoxysilane primer. The silicone piece did not swell or deform on contact with solvent based dispersion or after high temperature cure. This indicated silicone is suitable for the topcoat cure temperature and is solvent resistant. The blanket was print tested on a test fixture. Print IQ, as demonstrated in FIG. 5, provided adequate optical density of solid patch, low background, good half tones and good image sharpness.

## Claims

1. An imaging blanket for variable data lithography comprising:
a substrate;
a foam layer disposed on the substrate; and
an elastomeric layer disposed on the foam layer, the elastomeric layer comprising a silicone elastomer,
wherein the elastomeric layer has a Shore A hardness ranging from about 50 Shore A to about 100 Shore A.

2. The imaging blanket of claim 1, wherein at least one layer chosen from the foam layer and the elastomeric layer further comprises at least one thermally-conductive filler.

3. The imaging blanket of claim 2, wherein the at least one thermally-conductive filler is present in the elastomeric layer in an amount ranging from about 1% to about 15% by weight, based on the total weight of the elastomeric layer.

4. The imaging blanket of claim 1, wherein the foam layer has a Shore A hardness ranging from about 10 to about 50 Shore A.

5. The imaging blanket of claim 1, wherein the substrate comprises at least one material selected from the group consisting of metals, plastics, and woven fabrics.

6. The imaging blanket of claim 1, wherein the substrate does not include a fabric layer.

7. The imaging blanket of claim 1, further comprising a top coat comprising fluorosilicone and at least one infrared-absorbing filler.

8. The imaging blanket of claim 7, wherein the at least one infrared-absorbing filler is carbon black.

9. The imaging blanket of claim 7, wherein the elastomeric layer has a thermal conductivity ranging from about 0.5 W/m² to about 10 W/m².

10. The imaging blanket of claim 7, further comprising a primer layer disposed between the substrate and the top coat.

11. The imaging blanket of claim 1, wherein the elastomeric layer has a Shore A hardness ranging from about 60 Shore A to about 90 Shore A.

12. The imaging blanket of claim 1, wherein the elastomeric layer further comprises at least one catalyst.

13. The imaging blanket of claim 12, wherein the at least one catalyst is a platinum catalyst.

14. The imaging blanket of claim 1, wherein the silicone elastomer is a room temperature vulcanization silicone rubber.

15. The imaging blanket of claim 1, wherein the silicone elastomer does not include more than trace amounts of sulfur.

16. A method of making an imaging blanket for variable data lithography, the method comprising:
providing a substrate having a foam layer disposed thereon;
applying an elastomeric layer comprising a silicone elastomer to the foam layer; and
curing the elastomeric layer,
wherein the elastomeric layer has a Shore A hardness ranging from about 50 Shore A to about 100 Shore A.

17. The method of claim 16, wherein curing the elastomeric layer occurs at room temperature.

18. The method of claim 16, wherein the imaging blanket has a thermal conductivity ranging from about 0.5 W/m² to about 10 W/m².

19. The method of claim 16, further comprising:
applying a top coat comprising a fluorosilicone and at least one infrared-absorbing filler to the imaging blanket; and
curing the top coat.

20. A variable data lithography system, comprising:
an imaging member comprising an imaging blanket, the imaging blanket comprising:
a substrate;
a foam layer disposed on the substrate;
an elastomeric layer disposed on the foam layer, the elastomeric layer comprising a silicone elastomer, and
a top coat comprising fluorosilicone and at least one infrared-absorbing filler,
a fountain solution subsystem configured for applying a layer of fountain solution to the imaging blanket;
a patterning subsystem configured for selectively removing portions of the fountain solution layer so as to produce a latent image;
an inker subsystem configured for applying ink over the imaging blanket to thereby produce an ink image; and
an image transfer mechanism configured for transferring the ink image to a media substrate.
